# EUROPEAN PATENT APPLICATION

(11) **EP 4 703 730 A1**
(43) Date of publication of application: **04.03.2026**
(21) Application number: 25193888.2
(22) Date of filing: 04.08.2025
(51) Int. Cl.: G01P 1/00, G01P 15/125, G01P 15/13

(54) **ACCELEROMETER WITH BIAS REDUCTION FEATURE**

(30) Priority: 29.08.2024 US 202418819780
(71) Applicant: Honeywell International Inc., Charlotte, NC 28202 (US)
(72) Inventor: POLWARTH, Christina A., Charlotte, 28202 (US); DWYER, Paul W., Charlotte, 28202 (US); BECKA, Stephen F., Charlotte, 28202 (US)
(74) Representative: Haseltine Lake Kempner LLP

(57) **Abstract**

An accelerometer system including: a housing comprising a first portion and a second portion, the housing has a first coefficient of thermal expansion (CTE) value; and a proof mass element disposed between the first portion and the second portion of the housing, wherein a first surface of the proof mass element contacts the first portion and a second surface of the proof mass element contacts the second portion, the proof mass element having a second CTE value, the second CTE value being within 30% of the first CTE value.

## Description

### TECHNICAL FIELD

This disclosure relates to accelerometers.

### BACKGROUND

Accelerometers function by detecting a displacement of a proof mass under inertial forces. Some accelerometers include a capacitive pick-off system. For example, electrically conductive material (e.g., a capacitor plate) may be deposited on the upper surface of the proof mass, and similar electrically conductive material may be deposited on the lower surface of the proof mass. The proof mass may be suspended between non-moving members. When the accelerometer is subject to a vibration, the proof mass element may deflect in response to the forces and/or accelerations acting on the accelerometer. The deflection by the proof mass element may cause the distance (e.g., a capacitive gap) between capacitance plates on the proof mass element and non-moving members to vary. This variance in the capacitive gap causes a change in the capacitance of the capacitive elements, which is representative of the displacement of the proof mass along a sensitive axis. The change in the capacitance may be used as a displacement signal, which may be applied to a servo system that includes one or more electromagnets (e.g., a force-rebalancing coil) to return the proof mass to a null or at-rest position.

### SUMMARY

In general, the disclosure is directed to devices, systems, and techniques for reducing bias within an accelerometer system (e.g., within an accelerometer system containing a flexure accelerometer). Within the accelerometer, the proof mass element may be placed in contact with one or more surfaces of non-moving member(s) of the accelerometer. In some examples, where the proof mass element and the non-moving member(s) have different coefficients of thermal expansion (CTE), the proof mass element and the non-moving member(s) may expand and/or contract at different rates when the accelerometer is exposed to changes in temperature. The different ranges of expansion and/or contraction may induce a strain at or around interface(s) between the proof mass element and the non-moving member(s). The induced strain may be mis-interpreted as signals indicating a change in the acceleration applied on the accelerometer, which may lead to bias in the accelerometer system and reduce the accuracy of acceleration values outputted by the accelerometer system.

This disclosure describes devices, systems, and techniques for reducing the difference in CTE values between the proof mass element and the non-moving member(s). In some examples, different materials and/or different methods of manufacture are used to form a proof mass element with a CTE value within a threshold range of a CTE value of a material used to form the non-moving member(s) adjacent to the proof mass element within the accelerometer. By having the CTE values of the proof mass element and of the adjacent non-moving member(s) within a threshold range of each other, the proof mass element and the non-moving member(s) may expand and contract at a more similar rate in response to changes in temperature. The more similar rate may reduce thermally-induced strain at interfaces between the proof mass and the adjacent non-moving members, thereby reducing bias in the accelerometer system and improving the accuracy of the output by the accelerometer system.

In some examples, this disclosure describes an accelerometer system comprising: a housing comprising a first portion and a second portion, the housing having a first coefficient of thermal expansion (CTE) value; and a proof mass element disposed between the first portion and the second portion of the housing, wherein a first surface of the proof mass element contacts the first portion and a second surface of the proof mass element contacts the second portion, the proof mass element having a second CTE value, the second CTE value being within 30% of the first CTE value.

In some examples, this disclosure describes a method for assembling an accelerometer system, the method comprising: determining a first coefficient of thermal expansion (CTE) value of a housing, the housing comprising a first portion and a second portion; selecting, based on the first CTE value, a proof mass element with a second CTE value, the second CTE value being within 30% of the first CTE value; and disposing the proof mass element between the first portion and the second portion.

In some examples, this disclosure describes a proof mass for a flexure accelerometer, the proof mass comprising: an elongated body extending along a longitudinal axis and defining a first surface and a second surface, the second surface being opposite the first surface, wherein the first surface of the elongated body is configured to contact a first portion of a housing of the flexure accelerometer, wherein the second surface of the elongated body is configured to contact a second portion of the housing, wherein the housing has a first coefficient of thermal expansion (CTE) value, wherein the elongated body has a second CTE value, the second CTE value being within 30% of the first CTE value.

The summary is intended to provide an overview of the subject matter described in this disclosure. It is not intended to provide an exclusive or exhaustive explanation of the systems, device, and methods described in detail within the accompanying drawings and description below. Further details of one or more examples of this disclosure are set forth in the accompanying drawings and in the description below. Other features, objects, and advantages will be apparent from the description and drawings, and from the claims.

### BRIEF DESCRIPTION OF DRAWINGS

FIG. 1 is a conceptual diagram illustrating an exploded view of an example accelerometer system, in accordance with one or more techniques of this disclosure.
FIG. 2 is a conceptual diagram illustrating a side cutaway view of an example of the accelerometer system of FIG. 1.
FIG. 3 is a conceptual diagram illustrating a side cutaway view of the proof mass and non-moving member(s) of the accelerometer system of FIG. 2.
FIG. 4 is a plot illustrating example CTE values of different materials considered use in the accelerometer system of FIG. 1.
FIG. 5 is a flow chart illustrating an example technique for manufacturing the proof mass element of the accelerometer system of FIG. 1.

Like reference characters denote like elements throughout the description and figures.

### DETAILED DESCRIPTION

This disclosure is directed to devices, systems and techniques for determining an acceleration of an object using an accelerometer system. For example, the accelerometer system may be an electromagnetic accelerometer system configured to precisely measure acceleration values. The electromagnetic accelerometer system uses a combination of electrical signals and magnetic signals to determine the acceleration of the object. In some examples, the accelerometer system includes a proof mass element disposed between non-moving members, capacitive elements disposed on surfaces of the proof mass element, and electrical coils (e.g., an active coil and an inactive coil) disposed over opposite surfaces of the proof mass element.

In some cases, the accelerometer system is configured to measure the acceleration of the object in real-time or near real-time, such that processing circuitry may analyze the acceleration of the object over a period of time to determine a positional displacement of the object during the period of time. For example, the accelerometer system may be a part of an inertial navigation system (INS) for tracking a position of an object based, at least in part, on an acceleration of the object. Additionally, the accelerometer system may be located on or within the object such that the accelerometer system accelerates with the object. As such, when the object accelerates, the acceleration system (including the proof mass) accelerates with the object. Since acceleration over time is a derivative of velocity over time, and velocity over time is a derivative of position over time, processing circuitry may, in some cases, be configured to determine the position displacement of the object by performing a double integral of the acceleration of the object over the period of time. Determining a position of an object using the accelerometer system located on the object - and not using a navigation system external to the object (e.g., a global navigation satellite system (GNSS)) - may be referred to as "dead reckoning."

In some examples, the accelerometer system may include a flexure accelerometer such as, but is not limited to, the Q-Flex^{®} accelerometer available from Honeywell International, Inc. of Charlotte, North Carolina. The accelerometer system may experience vibrations and/or forces resulting from acceleration of the object. In response to the vibrations and/or forces, the proof mass element may deflect within the accelerometer. The deflection of the proof mass element may bring one or more capacitive elements closer to an electrical coil and/or bring one or more capacitive elements farther away from an electrical coil, e.g., thereby affecting a change in capacitance in the accelerometer which may be converted into displacement of the accelerometer. The displacement of the accelerometer may be used by the accelerometer system to determine the acceleration experienced by the accelerometer system.

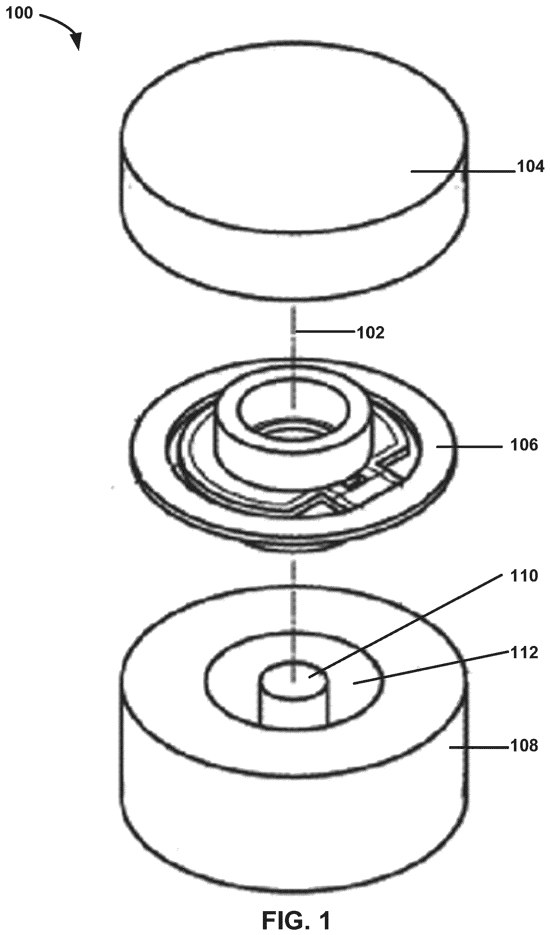

FIG. 1 is a conceptual diagram illustrating an exploded view of an example accelerometer system 100 (hereinafter "system 100"), in accordance with one or more techniques of this disclosure. As illustrated in FIG. 1, system 100 may include an accelerometer including, but is not limited to, a first non-moving member 104, a second non-moving member 108, and a proof mass element 106 disposed between first non-moving member 104 and second non-moving member 108 along a sensing axis 102 of system 100. The accelerometer may further include a pole piece 110 disposed within a housing of the accelerometer defined by non-moving members 104, 108 and extending along sensing axis 102.

Within the accelerometer, proof mass element 106 may be secured between non-moving members 104, 108. For example, a first surface of proof mass element 106 may be in contact with first non-moving member 104 and a second surface of proof mass element 106 may be in contact with second non-moving member 108.

In some examples, proof mass element 106 may define an elongated body extending along a longitudinal axis and defining the first surface and the second surface opposite the first surface. In such examples, the longitudinal axis of proof mass element 106 may be orthogonal to sensing axis 102 of system 100.

In other accelerometer systems, proof mass element 106 may be formed from a different material than non-moving members 104, 108. For example, in other accelerometer systems, proof mass element 106 is formed from a silica quartz and non-moving member 104, 108 are formed from Invar. In such examples, proof mass element 106 and non-moving members 104, 108 may have different coefficients of thermal expansion (CTE) and/or different CTE curves in response to changes in temperature.

In such examples, when the other accelerometer systems are subject to changes in temperature, the different CTE values and/or CTE curves, may cause proof mass element 106 to expand and/or contract at a different rate than non-moving member 104, 108, leading to increased strain at interfaces between proof mass element 106 and non-moving members 104, 108. The increased strain may be mis-interpreted by the other accelerometer systems as displacement of proof mass element 106, thereby reducing the accuracy of the determinations by the accelerometer systems and worsening the bias of the other accelerometer systems.

As will be described in greater detail below, proof mass element 106 of system 100 may be selected or manufactured with a CTE value and/or CTE curve within a threshold range of the CTE and/or CTE curve of non-moving members 104, 108. For example, the CTE value and/or CTE curve of proof mass element 106 may be up to ± 30% of the CTE value and/or CTE curve of non-moving members 104, 108 (e.g., alternatively described as being within 30% of the CTE value and/or CTE curve of non-moving members 104, 108). CTE curves may be described as being within a threshold range of each other when, at different temperatures, at least a threshold percentage of CTE values along each CTE curve is within the threshold range of the CTE values along the other CTE curve. The threshold range may be a specific difference in CTE values or a specific percentage difference from a selected CTE value.

When the proof mass element 106 and non-moving members 104, 108 have CTE values within the threshold range of each other, proof mass element 106 and non-moving members 104, 108 may expand and contract at a same or similar rate in response to changes in temperature in an environment containing system 100. In such examples, the expansion and/or contraction of proof mass element 106 and non-moving members 104, 108 at similar rates may reduce the strain between proof mass element 106 and non-moving members 104, 108, thereby reducing bias in the output of system 100.

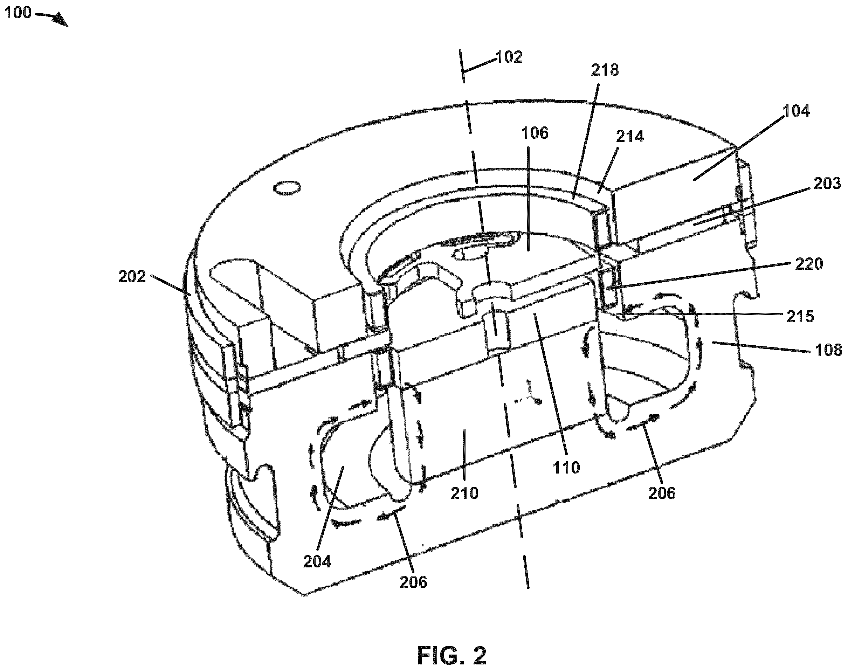

FIG. 2 is a conceptual diagram illustrating a side cutaway view of an example of system 100 of FIG. 1. As illustrated in FIG. 2, system 100 may include first non-moving member 104, proof mass element 106, and second non-moving member 108 arranged along sensing axis 102. An outer portion 203 of proof mass element 106 (e.g., alternative referred to herein as "reed 203") may be disposed between non-moving members 104, 108. Pole piece 110 may be disposed within a housing of system 100 formed by non-moving members 104, 108. In some examples, non-moving members 104, 108 are alternative referred to as first and second portions of the housing of the accelerometer of system 100. Non-moving members 104, 108 may define recesses 214, 215, respectively (e.g., alternatively referred to as "bores 214, 215"). Recesses 214, 215 may retain at least a portion of pole piece 110, a first coil 218, and a second coil 220.

Pole piece 110 may be disposed on top of a magnet 210 affixed to a surface of second non-moving member 108. A volume of space between magnet 210 and second non-moving member 108 may define a magnetic cavity 204 of system 100. System 100 may define a magnetic field 206 traveling through magnet 210 and second non-moving member 108 and around magnetic cavity 204, e.g., in the manner illustrated in FIG. 2.

First coil 218 may be electrically coupled to second coil 220 via strap 202. System 100 may direct an electrical current through first coil 218 and second coil 220. Coils 218, 220 may interface with magnetic field 206 to generate Lorentz forces acting on proof mass element 106. The Lorentz forces may act on proof mass element 106 to inhibit movement of proof mass element 106 within system 100, e.g., in response to external forces acting on system 100.

Reed 203 may be an outer portion of proof mass element 106 and may circumferentially and radially overlap with portions of non-moving members 104, 108. Reed 203 may be configured to elastically flex and/or deflect in response to forces acting on system 100. Reed 203 may include a capacitive element on each surface of reed 203. For example, reed 203 may include a first capacitive element along a first surface facing first non-moving member 104 and a second capacitive element along a second surface facing second non-moving member 108. Each of first surface or second surface may be alternatively referred to herein as an "outer surface" of proof mass element 106.

In some examples, when system 100 is at rest, reed 203 may not contact either of non-moving members 104, 108, and may maintain a specified distance between each capacitive element and a respective surface of one of non-moving members 104, 108.

When an external force is applied on system 100 and/or on an object system 100 is coupled to, the external force may cause at least a portion of reed 203 to elastically flex and/or deflect between non-moving members 104, 108. The movement of reed 203 between non-moving members 104, 108 may alter the distances between reed 203 and non-moving members 104, 108, thereby altering the capacitance of the capacitance elements on reed 203. This change in capacitance may be sensed by system 100 and may be used to determine the displacement of the accelerometer of system 100, and thereby the acceleration experienced by the accelerometer of system 100. A portion of reed 203 radially outwards of the capacitive elements may contact non-moving members 104, 108, e.g., to facilitate fixation of proof mass element 106 between non-moving members 104, 108.

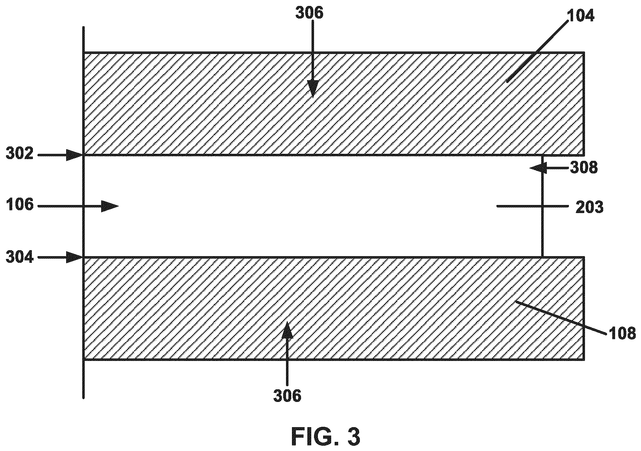

FIG. 3 is a conceptual diagram illustrating a side cutaway view of proof mass element 106 and non-moving members 104, 108 of system 100 of FIG. 2. As illustrated in FIG. 3, non-moving members 104, 108 may be formed from a first material 306 and proof mass element 106 (e.g., including reed 203) may be form from a second material 308. Second material 308 may be different from first material 306. First non-moving member 104 may interface with proof mass element 106 (e.g., may contact proof mass element 106) along surface 302. Second non-moving member 108 may interface with proof mass element 106 along surface 304.

First material 306 may include a magnetically permeable and/or electrically conductive metallic alloy. For example, first material 306 may allow for the travel of magnetic field 206 through non-moving members 104, 108 and/or allow for the travel of electrical current through non-moving members 104, 108. First material 306 may define a relatively low CTE, e.g., to reduce expansion and/or contraction of non-moving members 104, 108 in response to changes in temperature. The CTE of first material 306 may be about 1.5 x 10⁻⁶/°C (e.g., at room temperature). First material 306 may include, but is not limited to, one or more of Invar 36, Alloy 42, or Kovar.

Proof mass element 106 may be formed entirely or substantially from second material 308. Second material 308 may be uniform in chemical composition. In some examples, second material 308 may define an amorphous matrix within proof mass element 106. Second material 308 may include a silica-based material (e.g., a silica-based quartz) including, but is not limited to, a doped fused silica. Proof mass element 106 may be formed and/or the surfaces of proof mass element 106 may be treated via one or more microelectromechanical systems (MEMS) manufacturing techniques. MEMS manufacturing techniques may include, but are not limited to, photomasking techniques, chemical etching techniques, selective laser etching techniques, or metallization techniques.

Second material 308 may be formed or selected to have a CTE value within a threshold range of the CTE value for first material 306. In some examples, the threshold range is up to within 30% of the CTE value for first material 306 (i.e., ± 30% of the CTE value for first material 306). In some examples, the threshold range is within 0.5 x 10⁻⁶/°C of the CTE value for first material 306 (e.g., at room temperature). For example, if the CTE value of first material 306 is 1.5 x 10⁻⁶/°C at room temperature, second material 308 may be within the threshold range is the CTE value for second material 308 is between about 1.0 x 10⁻⁶/°C and about 2.0 x 10⁻⁶/°C.

A manufacturing assembly may select specific chemical compositions for second material 308 to cause second material 308 to have a CTE value within the threshold range of the CTE value for first material 306. For example, the manufacturing assembly may adjust the percentages of one or more elements within a silica material to cause the silica material to have a CTE value within the threshold range. The one or more elements may include, but are not limited to, boron, oxygen, sodium, aluminum, silicon or potassium. In one non-limiting example, second material 308 may have up to 1.6% boron, 1.1% sodium, 0.44% aluminum and 0.12% potassium, with the remainder comprising oxygen and silicon. By comparison, Pyrex contains up to 4% boron, 2.8% sodium, 1.1% aluminum, and 0.3% potassium, 54% oxygen, and 37.7% silicon.

With different CTE values, first material 306 and second material 308 may expand and/or contract at different rates when exposed to the same change in temperature. The difference in the rates of expansion and/or contraction may increase stress and/or strain at or around surfaces 302, 304. The increased stress and/or strain at or around surfaces 302, 304 may propagate through proof mass element 106 and/or cause flexure of proof mass element 106 (e.g., of portions of reed 203) unrelated to external forces acting on the accelerometer of system 100. The unintended flexure may lead to changes in capacitance of capacitance elements on proof mass element 106, which may be interpreted by system 100 to correspond to acceleration of the accelerometer, even if the accelerometer is stationary. Thus, the effects of different rates of expansion and/or contraction of materials 306, 308 when exposed to changes in temperature may alter the acceleration output of system 100, thereby introducing bias within system 100.

Selecting and/or manufacturing second material 308 to have a CTE value within a threshold range of the CTE value for first material 306 may reduce bias within system 100. Where the CTE value of second material 308 is within the threshold range of first material 306, first material 306 and second material 308 expand and/or contract at a same or substantially similar rate when exposed to a same change in temperature. The reduction in the difference in rates of expansion and/or contraction between first material 306 and second material 308 may reduce the stress and/or strain along surfaces 302, 304, which may reduce unintended flexure of proof mass element 106 and/or otherwise reduce changes in capacitance of capacitive elements on proof mass element 106 in response to changes in temperature, e.g., thereby reducing bias in system 100.

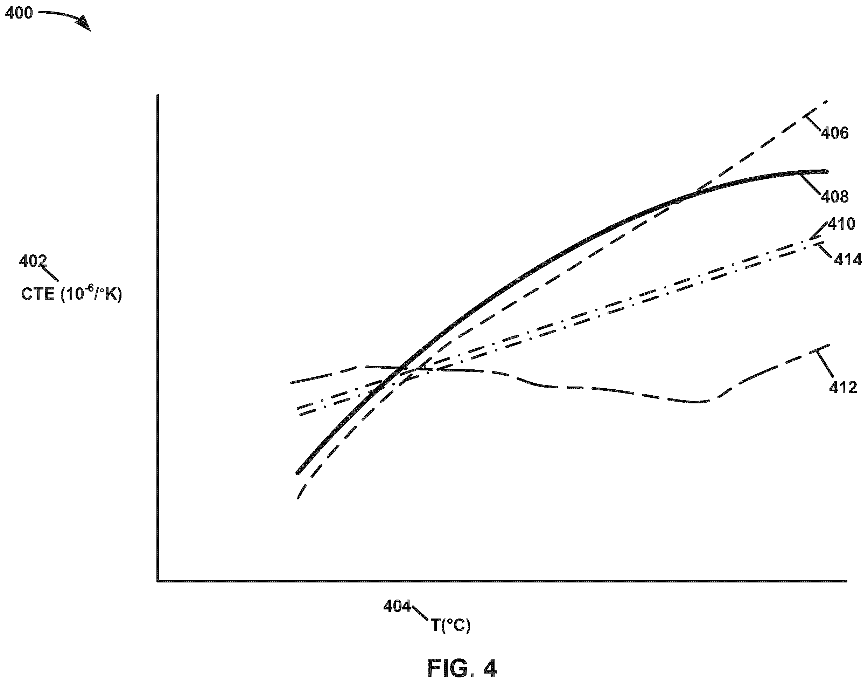

FIG. 4 is a plot 400 illustrating example CTE values of different materials considered for use in system 100 of FIG. 1. Plot 400 illustrates CTE curves 406, 408, 410, and 412 (collectively referred to as "CTE curves 406-412"), each of CTE curves 406-412 corresponding to a different material and illustrating CTE values 402 of the corresponding material at various temperatures 404.

CTE curves 406, 408, and 412 illustrate CTE curves of materials used to form proof mass elements in other accelerometer systems. CTE curve 406 may correspond to a glass substrate such as, but is not limited to, a SD-2 substrate. CTE curve 408 may correspond to a silicon element such as a silicon single crystal element. CTE curve 412 may correspond to a Borosilicate glass substrate.

CTE curve 410 illustrates the CTE curve of a material used to form non-moving members 104, 108 (e.g., Invar). As illustrated in plot 400, at different temperatures 404, each of CTE curves 406, 408, and 412 define different CTE values 402 than CTE curve 410. In other accelerometer systems, the differences between CTE values 402 at different temperatures causes the proof mass element and non-moving member to expand and/or contract at different rates, leading to bias in the accelerometer system.

Material 308 used to form proof mass element 106 may define a CTE curve identical to or substantially similar to the CTE curve of material 306 used to form non-moving members 104, 108. The CTE curves may be substantially similar if for at least a specified range of temperatures 404 (e.g., for temperatures greater than 100°C), the CTE values along the CTE curve for material 308 is within a threshold range of the CTE values along the CTE curve for material 306 (e.g., along CTE curve 410, in examples where material 306 is Invar). A non-limiting example CTE curve for material 308 is illustrated in FIG. 4 as CTE curve 414. Since CTE curves 410 and 414 are substantially similar at different temperatures 404 (e.g., define substantially similar CTE values 402 at various temperatures 404), materials 306 and 308 would expand and/or contract at a similar rate, thereby reducing stress and/or strain on proof mass element 106 and reducing bias in system 100. In some examples, where material 306 defines a different CTE curve than CTE curve 410, the CTE curve for material 308 may be different from CTE curve 414.

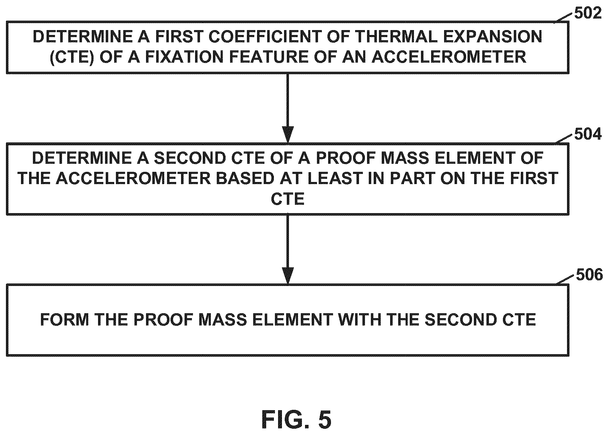

FIG. 5 is a flow chart illustrating an example technique for manufacturing the proof mass element of the accelerometer system of FIG. 1. While the technique illustrated in FIG. 5 is primarily described with reference to system 100 as illustrated in FIGS. 1-4, the techniques described below may be applied to form any proof mass element described herein. In addition, while the technique illustrated in FIG. 5 is primarily described as being performed by a manufacturing assembly, the technique may be performed by one or more of a manufacturer, two or more manufacturing assemblies, or a manufacturing system.

A manufacturing assembly may determine a first coefficient of thermal expansion (CTE) of a fixation feature of an accelerometer of an accelerometer system (e.g., system 100). The fixation feature may include non-moving members of the accelerometer, such as non-moving members 104, 108. Non-moving members 104, 108 may define first and second portions of a housing of the accelerometer and may secure a proof mass element of the accelerometer (e.g., proof mass element 106) between non-moving members 104, 108 along sensing axis 102 of system 100.

Non-moving members 104, 108 may be formed from a same material (e.g., material 306). Material 306 may define a CTE curve (e.g., CTE curve 410) with different CTE values 402 at different temperatures 404. A rate of thermal expansion and/or thermal contraction of non-moving members 104, 108 in response to changes in temperature may be based on CTE values 402 and/or the CTE curve of material 306. Material 306 may include, but is not limited to, Invar, Alloy 42, or Kovar. The manufacturing assembly may determine the CTE of non-moving members 104, 108 (e.g., CTE values 402 of non-moving members 104, 108 at specific temperatures (e.g., at room temperature), CTE curve for non-moving members 104, 108) based on material 306 used to form non-moving members 104, 108 and/or by subjecting non-moving members 104, 108 to thermal expansion tests.

The manufacturing assembly may determine a second CTE of proof mass element 106 of the accelerometer based at least in part on the first CTE (504). Within the accelerometer, proof mass element 106 is in contact with non-moving members 104, 108. When the second CTE of proof mass element 106 is the same as or substantially similar to the first CTE of non-moving members 104, 108, proof mass element 106 may expand and/or contract at a same or similar rate as non-moving members 104, 108 in response to a same change in temperature 404. The same or similar rate of thermal expansion and/or contraction between proof mass element 106 and non-moving members 104, 108 may reduce the stress and/or strain at interfaces between proof mass element 106 and non-moving members 104, 108, e.g., in response to differences in rates of thermal expansion and/or contraction between the components. The reduction in stress and/or strain may reduce changes in capacitance of capacitive elements on proof mass element 106 in response to the stress and/or strain, thereby reducing bias in system 100 due to the effects of thermal expansion and/or contraction of components within system 100.

The manufacturing assembly may select the second CTE of proof mass element 106 to be the same or substantially similar to the first CTE of non-moving members 104, 108, e.g., to reduce bias in system 100 as described above. In some examples, the manufacturing assembly selects, for the second CTE, CTE values 402 at specific temperatures 404 that are within a threshold range of a corresponding CTE value 402 for non-moving members 104, 108 at the same temperatures 404. In some examples, the manufacturing assembly selects, for the second CTE, a second CTE curve with CTE values 402 within a threshold range of corresponding CTE values 402 on a first CTE curve for non-moving members 104, 108 within at least a threshold range of temperatures 404. The threshold range may be a specified value (e.g., 0.5 x 10⁻⁶/°C) or a specific percentage of a first CTE value 402 (e.g., up to 30% of the respective first CTE value 402).

The manufacturing assembly may form proof mass element 106 with the second CTE (506). The manufacturing assembly may form proof mass element 106 with one or more MEMS manufacturing techniques including, but not limited to, photomasking, chemical etching, selective laser etching, or metallization. When formed, proof mass element 106 may define a single element formed from a single material 308. When formed, proof mass element 106 may define an amorphous matrix.

In some examples, the manufacturing assembly adjusts the percentages of one or more elements within a silicon-based glass, crystal, or substrate, to form material 308 with the second CTE. The manufacturing assembly may then form proof mass element 106 using material 308. The one or more elements may include, but are not limited to, boron, oxygen, sodium, aluminum, silicon, and potassium. For example, material 308 may include less boron, sodium, aluminum, and potassium compared to other silicon-based materials (e.g., Pyrex) and defines a second CTE substantially similar to a first CTE for material 306 (e.g., Invar). In some examples, the manufacturing assembly iteratives forms different materials, determines the CTEs for the different materials, and compares the determined the CTEs against the determined second CTE until the manufacturing assembly determines that a specific material has a CTE the same as or substantially similar to the second CTE and/or the first CTE. In some examples, the manufacturing assembly retrieves the stored CTE values for a plurality of previously-formed materials and selects material 308 used to form proof mass element 106 based on a determination that the corresponding stored CTE value is the same as or substantially similar to the second CTE and/or the first CTE.

This disclosure describes the following examples:
Example 1: an accelerometer system comprising: a housing comprising a first portion and a second portion, the housing having a first coefficient of thermal expansion (CTE) value; and a proof mass element disposed between the first portion and the second portion of the housing, wherein a first surface of the proof mass element contacts the first portion and a second surface of the proof mass element contacts the second portion, the proof mass element having a second CTE value, the second CTE value being within 30% of the first CTE value.
Example 2: the accelerometer system of example 1, wherein the first CTE value is 1.5 x 10⁻⁶/°C, and wherein the second CTE value is between about 1.0 x 10⁻⁶/°C and about 2.0 x 10⁻⁶/°C.
Example 3: the accelerometer system of any of examples 1 or 2, wherein each of the first portion or the second portion of the housing is formed from one or more of: Invar 36; Alloy 42; or Kovar.
Example 4: the accelerometer system of any of examples 1-3, wherein the proof mass element defines an amorphous matrix.
Example 5: the accelerometer system of any of examples 1-4, wherein the proof mass element is formed from a doped fused silica.
Example 6: the accelerometer system of any of examples 1-5, wherein the accelerometer system comprises a flexure accelerometer.
Example 7: the accelerometer system of any of examples 1-6, wherein the first CTE value is substantially similar to a CTE value of one or more of: Invar 36; Alloy 42; or Kovar.
Example 8: the accelerometer system of any of examples 1-7, wherein the proof mass element is formed from one or more of: a photomasking technique; a chemical etching technique; a selective laser etching technique; or a metallization technique.
Example 9: a method for assembling an accelerometer system, the method comprising: determining a first coefficient of thermal expansion (CTE) value of a housing, the housing comprising a first portion and a second portion; selecting, based on the first CTE value, a proof mass element with a second CTE value, the second CTE value being within 30% of the first CTE value; and disposing the proof mass element between the first portion and the second portion.
Example 10: the method of example 9, wherein the first CTE value is 1.5 x 10⁻⁶/°C, and wherein the second CTE value is between about 1.0 x 10⁻⁶/°C and about 2.0 x 10⁻⁶/°C.
Example 11: the method of any of examples 9 or 10, wherein each of the first portion or the second portion of the housing is formed from one or more of: Invar 36; Alloy 42; or Kovar.
Example 12: the method of any of examples 9-11, wherein the proof mass element defines an amorphous matrix.
Example 13: the method of any of examples 9-12, wherein the proof mass element is formed from a doped fused silica.
Example 14: the method of any of examples 9-13, wherein the accelerometer system comprises a flexure accelerometer.
Example 15: the method of any of examples 9-14, wherein the first CTE value is substantially similar to a CTE value of one or more of: Invar 36; Alloy 42; or Kovar.
Example 16: the method of any of examples 9-15, further comprising:
prior to disposing the proof mass element between the first portion and the second portion, treating at least one outer surface of the proof mass element using one or more of: a photomasking technique; a chemical etching technique; a selective laser etching technique; or a metallization technique.
Example 17: a proof mass for a flexure accelerometer, the proof mass comprising: an elongated body extending along a longitudinal axis and defining a first surface and a second surface, the second surface being opposite the first surface, wherein the first surface of the elongated body is configured to contact a first portion of a housing of the flexure accelerometer, wherein the second surface of the elongated body is configured to contact a second portion of the housing, wherein the housing has a first coefficient of thermal expansion (CTE) value, wherein the elongated body has a second CTE value, the second CTE value being within 30% of the first CTE value.
Example 18: the proof mass of example 17, wherein the second CTE value is between about 1.0 x 10⁻⁶/°C and about 2.0 x 10⁻⁶/°C.
Example 19: the proof mass of any of examples 17 or 18, wherein the elongated body is formed from a doped fused silica.
Example 20: the proof mass of any of examples 17-19, wherein the elongated body is formed from one or more of: a photomasking technique; a chemical etching technique; a selective laser etching technique; or a metallization technique.

In one or more examples, the accelerometers described herein may utilize hardware, software, firmware, or any combination thereof for achieving the functions described. Those functions implemented in software may be stored on or transmitted over, as one or more instructions or code, a computer-readable medium and executed by a hardware-based processing unit. Computer-readable media may include computer-readable storage media, which corresponds to a tangible medium such as data storage media, or communication media including any medium that facilitates transfer of a computer program from one place to another, e.g., according to a communication protocol. In this manner, computer-readable media generally may correspond to (1) tangible computer-readable storage media which is non-transitory or (2) a communication medium such as a signal or carrier wave. Data storage media may be any available media that can be accessed by one or more computers or one or more processors to retrieve instructions, code and/or data structures for implementation of the techniques described in this disclosure.

Instructions may be executed by one or more processors within the accelerometer or communicatively coupled to the accelerometer. The one or more processors may, for example, include one or more DSPs, general purpose microprocessors, application specific integrated circuits ASICs, FPGAs, or other equivalent integrated or discrete logic circuitry. Accordingly, the term "processor," as used herein may refer to any of the foregoing structure or any other structure suitable for implementation of the techniques described herein. In addition, in some aspects, the functionality described herein may be provided within dedicated hardware and/or software modules configured for performing the techniques described herein. Also, the techniques could be fully implemented in one or more circuits or logic elements.

The techniques of this disclosure may be implemented in a wide variety of devices or apparatuses that include integrated circuits (ICs) or sets of ICs (e.g., chip sets). Various components, modules, or units are described in this disclosure to emphasize functional aspects of devices configured to perform the disclosed techniques, but do not necessarily require realization by different hardware units. Rather, various units may be combined or provided by a collection of interoperative hardware units, including one or more processors as described above, in conjunction with suitable software and/or firmware.

## Claims

1. An accelerometer system comprising:
a housing comprising a first portion and a second portion, the housing having a first coefficient of thermal expansion (CTE) value; and
a proof mass element disposed between the first portion and the second portion of the housing, wherein a first surface of the proof mass element contacts the first portion and a second surface of the proof mass element contacts the second portion, the proof mass element having a second CTE value, the second CTE value being within 30% of the first CTE value.

2. The accelerometer system of claim 1, wherein the first CTE value is 1.5 x 10⁻⁶/°C, and wherein the second CTE value is between about 1.0 x 10⁻⁶/°C and about 2.0 x 10⁻⁶/°C.

3. The accelerometer system of any of claims 1 and 2, wherein each of the first portion or the second portion of the housing is formed from one or more of:
Invar 36;
Alloy 42; or
Kovar.

4. The accelerometer system of any of claims 1-3, wherein the proof mass element defines an amorphous matrix.

5. The accelerometer system of any of claims 1-4, wherein the proof mass element is formed from a doped fused silica.

6. The accelerometer system of any of claims 1-5, wherein the accelerometer system comprises a flexure accelerometer.

7. The accelerometer system of any of claims 1-6, wherein the first CTE value is substantially similar to a CTE value of one or more of:
Invar 36;
Alloy 42; or
Kovar.

8. The accelerometer system of any of claims 1-7, wherein the proof mass element is formed from one or more of:
a photomasking technique;
a chemical etching technique;
a selective laser etching technique; or
a metallization technique.

9. A method for assembling an accelerometer system, the method comprising:
determining a first coefficient of thermal expansion (CTE) value of a housing, the housing comprising a first portion and a second portion;
selecting, based on the first CTE value, a proof mass element with a second CTE value, the second CTE value being within 30% of the first CTE value; and
disposing the proof mass element between the first portion and the second portion.

10. The method of claim 9, wherein the first CTE value is 1.5 x 10⁻⁶/°C, and wherein the second CTE value is between about 1.0 x 10⁻⁶/°C and about 2.0 x 10⁻⁶/°C.

11. The method of any of claims 9 and 10, wherein each of the first portion or the second portion of the housing is formed from one or more of:
Invar 36;
Alloy 42; or
Kovar.

12. A proof mass for a flexure accelerometer, the proof mass comprising:
an elongated body extending along a longitudinal axis and defining a first surface and a second surface, the second surface being opposite the first surface,
wherein the first surface of the elongated body is configured to contact a first portion of a housing of the flexure accelerometer, wherein the second surface of the elongated body is configured to contact a second portion of the housing, wherein the housing has a first coefficient of thermal expansion (CTE) value,
wherein the elongated body has a second CTE value, the second CTE value being within 30% of the first CTE value.

13. The proof mass of claim 12, wherein the second CTE value is between about 1.0 x 10⁻⁶/°C and about 2.0 x 10⁻⁶/°C.

14. The proof mass of any of claims 12 and 13, wherein the elongated body is formed from a doped fused silica.

15. The proof mass of any of claims 12-14, wherein the elongated body is formed from one or more of:
a photomasking technique;
a chemical etching technique;
a selective laser etching technique; or
a metallization technique.
